(19) Europäisches Patentamt
European Patent Office
Office européen des brevets

(11) **EP 4 783 058 A1**

(12) **EUROPÄISCHE PATENTANMELDUNG**

(43) Veröffentlichungstag:
29.07.2026 Patentblatt 2026/31

(21) Anmeldenummer: 25153223.0

(22) Anmeldetag: 22.01.2025

(51) Internationale Patentklassifikation (IPC):
*G06F 30/15* (2020.01) *B60W 50/00* (2006.01)
*G06F 30/20* (2020.01)

(52) Gemeinsame Patentklassifikation (CPC):
**G06F 30/20; B60T 8/17551; B60W 50/00;**
**G06F 30/15;** B60L 2240/18; B60T 2270/86;
B60W 2050/0028; B60W 2050/0031; B60W 2552/30

(84) Benannte Vertragsstaaten:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Benannte Erstreckungsstaaten:
**BA**
Benannte Validierungsstaaten:
**GE KH MA MD TN**

(71) Anmelder: **Robert Bosch GmbH**
**70442 Stuttgart (DE)**

(72) Erfinder:
• **Schmidt, Kevin**
**71083 Herrenberg (DE)**
• **Henkelmann, Nicola**
**71665 Vaihingen/Enz (DE)**

(54) **VERFAHREN FÜR EINE IDENTIFIKATION VON PARAMETERVERTEILUNGEN ZUR MODELLIERUNG EINES TECHNISCHEN SYSTEMS**

(57) Die Erfindung betrifft ein Verfahren (100) für eine Identifikation von Parameterverteilungen zur Modellierung eines technischen Systems (50), umfassend die nachfolgenden Schritte:

- Bestimmen (101) einer nominalen Parameterschätzung basierend auf bereitgestellten Messdaten und wenigstens einem vorgegebenen Modell einer Systemdynamik des technischen Systems (50),

- Bestimmen (102) einer Verteilung von Parameterveränderungen auf Basis einer Quantifizierung einer parameterbedingten Unsicherheit der nominalen Parameterschätzung,

- Bereitstellen (103) der nominellen Parameterschätzung und der Verteilung der Parameterveränderungen als Basis für die Modellierung des technischen Systems (50) unter Berücksichtigung der parameterbedingten Unsicherheit.

**Fig. 1**

**Beschreibung**

Die Erfindung betrifft ein Verfahren für eine Identifikation von Parametern zur Modellierung eines technischen Systems. Ferner betrifft die Erfindung ein Computerprogramm, eine Vorrichtung sowie ein Speichermedium zu diesem Zweck.

Stand der Technik

Die Bestimmung von Systemparametern ist ein zentrales Element des modellbasierten Entwurfs. Dabei ist von großer Bedeutung, wie gut das Modell die Realität beschreiben kann. Viele Aussagen, wie z. B. Performancegarantien, Safety-Aussagen, Einhaltung von Beschränkungen, Ausfallwahrscheinlichkeiten und dergleichen, hängen maßgeblich davon ab.

Folglich sind aus dem Stand der Technik bereits einige Verfahren bekannt, die sich mit der Identifikation von Systemparametern auf Basis von Messdaten beschäftigen. Typischerweise wird lediglich ein nomineller Parametersatz bestimmt, der die Lösung eines Optimierungsproblems darstellt. Die verbleibende Unsicherheit wird allerdings oft nicht oder nur implizit berücksichtigt, obwohl sie für viele nachgelagerte Entscheidungen von Relevanz ist.

Ferner verwenden Methoden der inversen "Uncertainty Quantification" die Bayes'sche Statistik, um Verteilungen von Parametern zu bestimmen. Diese Methoden können im Rahmen von "probabilistic programming" implementiert werden. Die Anwendung erfordert ein hohes Maß an Expertenwissen. Weitere Anforderungen an die Implementierung des Modells schränken die Nutzbarkeit weiter ein. Das Applizieren dieser Methoden ist mit erheblichem Zeit- und Kostenaufwand verbunden und schwer in einen bestehenden Ablauf zur Modellidentifikation zu integrieren.

Offenbarung der Erfindung

Gegenstand der Erfindung ist ein Verfahren mit den Merkmalen des Anspruchs 1, ein Computerprogramm mit den Merkmalen des Anspruchs 9, eine Vorrichtung mit den Merkmalen des Anspruchs 10 sowie ein computerlesbares Speichermedium mit den Merkmalen des Anspruchs 11. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Computerprogramm, der erfindungsgemäßen Vorrichtung sowie dem erfindungsgemäßen computerlesbaren Speichermedium, und jeweils umgekehrt, so dass bezüglich der Offenbarung der Erfindung stets auch eine wechselseitige Bezugnahme möglich ist.

Gegenstand der Erfindung ist insbesondere ein Verfahren für eine Identifikation von Parametern und/oder Parameterverteilungen und/oder zur Unsicherheitsquanitifizierung und/oder zur Modellierung eines technischen Systems.

Das Verfahren kann ein Bestimmen einer nominalen Parameterschätzung basierend auf bereitgestellten Messdaten und wenigstens einem vorgegebenen Modell einer Systemdynamik des technischen Systems umfassen.

Ferner kann das Verfahren ein Bestimmen einer Verteilung von Parameterveränderungen (bzw. einem stochastischen Anteil) auf Basis einer Quantifizierung einer parameterbedingten Unsicherheit der nominalen Parameterschätzung umfassen.

Darüber hinaus kann das Verfahren ein Bereitstellen der nominellen Parameterschätzung und der Verteilung der Parameterveränderungen als Basis für die Modellierung des technischen Systems unter Berücksichtigung der parameterbedingten Unsicherheit umfassen.

Erfindungsgemäß kann der Vorteil erzielt werden, dass ein Modell des technischen Systems bereitgestellt werden kann, das sowohl die nominalen Parameterwerte als auch deren Unsicherheiten berücksichtigt. Dies ermöglicht eine genauere und zuverlässigere Modellierung des Systems, da potenzielle Schwankungen der Parameter erfasst werden. Die Berücksichtigung von Unsicherheiten im Modell führt zu robusteren Steuerungsstrategien und einer verbesserten Zuverlässigkeit des technischen Systems, insbesondere in Anwendungen mit hohen Anforderungen, wie z. B. im Automobilbereich.

Erfindungsgemäß wird ein zweistufiger Ansatz zur Identifikation von zuverlässigeren Modellparametern vorgeschlagen. In einem ersten Schritt kann der nominelle Fehler zwischen den zur Verfügung stehenden Daten und dem Modell ohne Berücksichtigung von Unsicherheiten minimiert werden. Die verbleibende Modell-Unsicherheit um diese Schätzung kann so dann über einen linearisierten Bayes'schen Ansatz charakterisiert werden.

Im Vergleich zu herkömmlichen nichtlinearen Bayes'schen Methoden können die erfindungsgemäß erhaltenen Schätzungen aufgrund der Linearisierung ggf. konservativer sein. Allerdings ergeben sich auch signifikante Vorteile, welche im Folgenden weiter erläutert werden.

So bietet die Erfindung ggf. den Vorteil, dass keine Voraussetzungen einer bestimmten Modellstruktur erfüllt werden müssen. Als Modellschnittstelle kann lediglich die Vorgabe der Eingangsgrößen, der zu identifizierenden Parametern und das Auslesen der korrespondieren Systemantwort benötigt werden. Somit kann die Methode auf komplexe numerische Modelle angewendet werden, ohne eine analytische Beschreibung zu erfordern.

Zusätzliche Strukturannahmen ermöglichen eine effiziente Auswertung der benötigten Linearisierung und der Bayes'schen Regression. Letzteres ermöglicht die Verwendung zur Laufzeit des betrachteten technischen Systems.

Die Bayes'sche Statistik kann ferner gekapselt werden, sodass eine breite Anwendbarkeit ohne explizites Expertenwissen ermöglicht wird. Die Verwendung einer Statistik zweiter Ordnung, d.h. die Parameter werden intern durch einen Mittelwert und eine (Ko-)Varianz beschrieben, ermöglichen eine geschlossene Lösung des linearisierten Bayes'schen Regressionsproblems.

Die sich ergebenen Linearisierungsfehler können ferner quantifiziert werden und im Rahmen der Modellunsicherheit im Entwurf berücksichtigt werden.

Ferner können bestehende nominelle Parameterschätzungen in die Methode integriert werden. Diese können im Rahmen der Erfindung bestätigt, verbessert oder verworfen werden.

Eine mögliche Anwendung der Erfindung ist bspw. die Systemidentifikation für Fahrzeugmodelle, die für die Fahrzeugquerführung, -längsführung, Fahrdynamikregelung oder Komponentenentwicklung eingesetzt werden.

Außerdem ist es von Vorteil, wenn das Verfahren zur Identifikation der Parameter in der Form von Modellparametern eines geschlossenen Regelkreises zur Fahrzeug-Kontrolle und vorzugsweise Fahrzeug-Querführung eingesetzt wird. Dadurch kann die vorgeschlagene Lösung zur Parameteridentifizierung direkt in realen Fahrzeugsystemen angewendet werden, um beispielsweise das Verhalten des Fahrzeugs bei Kurvenfahrten präziser zu modellieren und somit die Stabilität und Sicherheit zu verbessern.

Ferner kann es im Rahmen der Erfindung vorgesehen sein, dass das Verfahren für eine Identifikation der Parameter für Fahrzeugmodelle vorgesehen ist, die vorzugsweise für die Fahrzeugquerführung und/oder Fahrzeuglängsführung und/oder Fahrdynamikregelung und/oder Komponentenentwicklung und/oder Lenkungsregelung und/oder Bremsregelung eingesetzt werden. Dadurch wird insbesondere erreicht, dass das Verfahren eine verbesserte Identifikation von Parametern und/oder Parameterverteilungen in verschiedenen Bereichen der Fahrzeugtechnik ermöglicht.

Optional ist es denkbar, dass das Verfahren zur Untersuchung eines Übertragungsverhaltens von einer gewünschten Krümmung einer Fahrzeugtrajektorie auf eine tatsächliche Krümmung der Fahrzeugtrajektorie eingesetzt wird, wobei die nachfolgenden Schritte vorgesehen sind:

- Bereitstellen des vorgegebenen Modells in der Form eines Modells eines geschlossenen Regelkreises zur Fahrzeug-Querführung, und/oder
- Durchführen der nominalen Parameterschätzung, um eine erste Schätzung wenigstens eines Parameters des Modells auf Basis der bereitgestellten Messdaten vorzunehmen, und/oder
- Durchführen der Quantifizierung der parameterbedingten Unsicherheit, welche eine verbleibende Unsicherheit in den geschätzten Parametern bereitstellt, und/oder
- Durchführen der Bestimmung der Verteilung der Parameterveränderungen auf Basis der durchgeführten Quantifizierung, und/oder
- Durchführung der Modellierung des technischen Systems auf Basis der nominellen Parameterschätzung und der Verteilung der Parameterveränderungen, und/oder
- Anpassen einer Regelungsvorgabe für die Fahrzeug-Querführung auf Basis der Modellierung.

Somit kann das Verfahren zur Ermittlung von Parametern und/oder Parameterverteilungen, die ein Übertragungsverhalten von der gewünschten Krümmung einer Fahrzeugtrajektorie auf die tatsächliche Krümmung beeinflussen, verwendet werden. Die Modellierung des Systems unter Berücksichtigung der Unsicherheiten in den Parametern ermöglicht eine Anpassung der Regelungsvorgabe für die Fahrzeug-Querführung, um ein genaueres Verhalten zu erzielen und die Sicherheit zu erhöhen.

Auch ist es optional denkbar, dass die Bestimmung der nominalen Parameterschätzung umfasst: Minimieren eines nominellen Fehlers zwischen den bereitgestellten Messdaten und dem vorgegebenen Modell, insbesondere ohne Berücksichtigung von Unsicherheiten. Mit anderen Worten umfasst die Berechnung des nominalen Parameterwerts das Minimieren eines minimalen Abweichungswertes zwischen den zur Verfügung stehenden Messdaten, insbesondere Messwerten, und dem Modell.

Gemäß einer vorteilhaften Weiterbildung der Erfindung kann vorgesehen sein, dass die Bestimmung der Verteilung der Parameterveränderungen umfasst:
Charakterisieren der parameterbedingten Unsicherheit in der Form einer aus der nominalen Parameterschätzung verbleibenden Modell-Unsicherheit. Dies ermöglicht eine quantitative Beurteilung der Einflussnahme einzelner Parameter auf das Systemverhalten.

Nach einer weiteren Möglichkeit kann vorgesehen sein, dass die Bestimmung der Verteilung und insbesondere die Charakterisierung der parameterbedingten Unsicherheit mittels eines linearisierten Bayes'schen Ansatzes durchgeführt wird. Mit anderen Worten kann das Verfahren vorzugsweise eine lineare Approximation des Systems verwenden, um die Parameterverteilung zu charakterisieren.

Optional ist es denkbar, dass die Modellierung des technischen Systems unter Berücksichtigung der parameterbedingten Unsicherheit dadurch vorgesehen ist, dass die nominale Parameterschätzung und die Verteilung der Parameterveränderungen zu einer Gesamtschätzung konsolidiert werden. Mit anderen Worten wird die nominelle Parameterschätzung und die Verteilung der Parameterveränderungen vorzugsweise kombiniert, um eine umfassende Schätzung des Systems zu erhalten, die sowohl den Mittelwert als auch die Unsicherheit der Parameter berücksichtigt. Dies ermöglicht ein realistischeres und robusteres Modell des technischen Systems.

Es ist möglich, dass das erfindungsgemäße Verfahren bei einem Fahrzeug zum Einsatz kommt. Das Fahrzeug kann bspw. als ein Kraftfahrzeug und/oder Personenkraftfahrzeug und/oder zumindest teilweise automatisiertes/autonomes Fahrzeug ausgebildet sein. Das Fahrzeug kann eine Fahrzeugeinrichtung, bspw. zur Bereitstellung einer autonomen Fahrfunktion, und/oder ein Fahrerassistenzsystem aufweisen. Die Fahrzeugeinrichtung kann dazu ausgeführt sein, das Fahrzeug zumindest teilweise automatisch zu steuern und/oder zu beschleunigen und/oder abzubremsen und/oder zu lenken.

Ebenfalls Gegenstand der Erfindung ist ein Computerprogramm, insbesondere Computerprogrammprodukt, umfassend Befehle, die bei der Ausführung des Computerprogrammes durch wenigstens einen Computer diesen veranlassen, das erfindungsgemäße Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind.

Ebenfalls Gegenstand der Erfindung ist eine Vorrichtung zur Datenverarbeitung, die eingerichtet ist, das erfindungsgemäße Verfahren auszuführen. Als die Vorrichtung kann bspw. wenigstens ein Computer vorgesehen sein, welcher das erfindungsgemäße Computerprogramm ausführt. Der Computer kann wenigstens einen Prozessor zur Ausführung des Computerprogramms aufweisen. Auch kann ein nicht-flüchtiger Datenspeicher vorgesehen sein, in welchem das Computerprogramm hinterlegt und von welchem das Computerprogramm durch den Prozessor zur Ausführung ausgelesen werden kann.

Ebenfalls Gegenstand der Erfindung kann ein computerlesbares Speichermedium sein, welches das erfindungsgemäße Computerprogramm aufweist und/oder Befehle umfasst, die bei der Ausführung durch wenigstens einen Computer diesen veranlassen, das erfindungsgemäße Verfahren auszuführen. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer integriert sein.

Darüber hinaus kann das erfindungsgemäße Verfahren auch als ein computerimplementiertes Verfahren ausgeführt sein. Alternativ oder zusätzlich kann zumindest einer der offenbarten Verfahrensschritte computer-implementiert sein und/oder automatisiert durchgeführt werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:

Fig. 1    eine schematische Visualisierung eines Verfahrens, einer Vorrichtung, eines Speichermediums sowie eines Computerprogramms gemäß Ausführungsbeispielen der Erfindung.

Fig. 2:    Eine Einbettung der Systemidentifikation gemäß Ausführungsvarianten der Erfindung in das V-Modell.

Fig. 3    Ein beispielhaftes Ablaufdiagramm zur Identifikation der Parameter und deren Unsicherheit gemäß Ausführungsvarianten der Erfindung.

Fig. 4    Eine Visualisierung des technischen Systems sowie des Problems, welches Ausführungsvarianten der Erfindung zugrunde liegt.

Fig. 5    Eine weitere beispielhafte Visualisierung der Anwendung von Ausführungsvarianten der Erfindung.

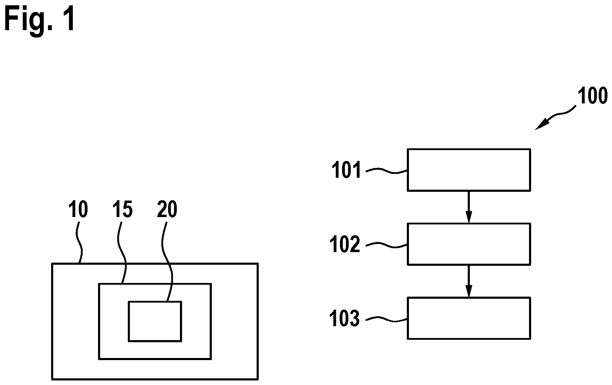

In Fig. 1 sind ein Verfahren 100, eine Vorrichtung 10, ein Speichermedium 15 sowie ein Computerprogramm 20 gemäß Ausführungsbeispielen der Erfindung schematisch dargestellt.

Gemäß Ausführungsbeispielen der Erfindung ist das Verfahren 100 für eine Identifikation von Parametern und/oder Parameterverteilungen zur Modellierung eines technischen Systems 50 vorgesehen. Gemäß einem ersten Verfahrensschritt 101 erfolgt hierbei ein Bestimmen einer nominalen Parameterschätzung basierend auf bereitgestellten Messdaten D und wenigstens einem vorgegebenen Modell einer Systemdynamik des technischen Systems 50. Das technische System 50 betrifft vorzugsweise ein Fahrzeug, wie im Folgenden noch weiter beschrieben wird. Die Systemdynamik kann z. B. Quersteifigkeiten und/oder Fahrzeugparameter und/oder Umgebungsparameter und/oder Reifenkennlinien betreffen.

Gemäß einem zweiten Verfahrensschritt 102 erfolgt ein Bestimmen einer Verteilung von Parameterveränderungen auf Basis einer Quantifizierung einer parameterbedingten Unsicherheit der nominalen Parameterschätzung. Insbesondere wird hierbei eine Verteilung für einen stochastischen Anteil bestimmt.

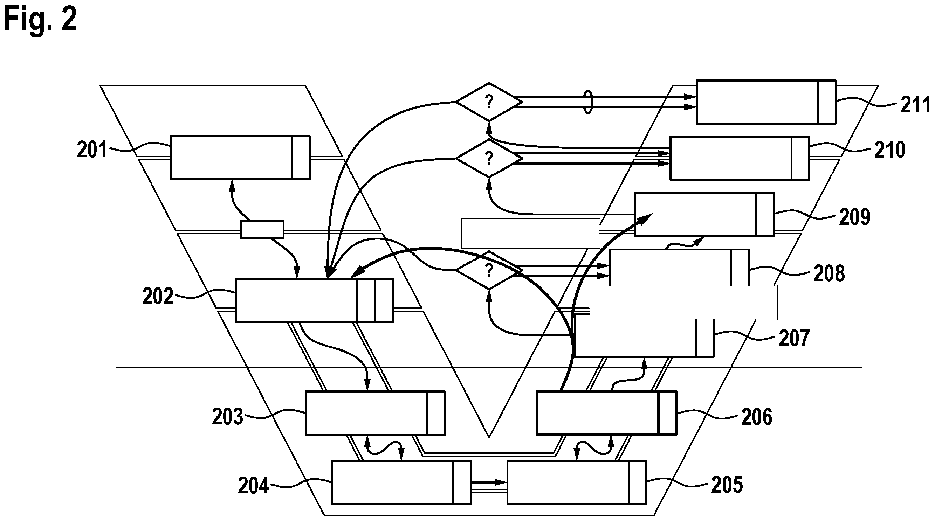

Gemäß einem dritten Verfahrensschritt 103 erfolgt ein Bereitstellen der nominellen Parameterschätzung und der Verteilung der Parameterveränderungen als Basis für die Modellierung des technischen Systems 50 unter Berücksichtigung der parameterbedingten Unsicherheit. Mit anderen Worten kann die Modellierung auf Basis der Ergebnisse der vorangehenden Verfahrensschritte 101 und 102 durchgeführt werden. Ausführungsvarianten der Erfindung können ein zentraler Bestandteil der Systemidentifikation sein (siehe bspw. 206 in Fig. 2), sodass mit anderen Worten die Modellierung entsprechend zur Systemidentifikation eines technischen Systems 50 herangezogen werden kann.

In Fig. 2 wird ein V-Modell dargestellt, das verschiedene Stufen und Prozesse im Entwicklungszyklus illustriert. Dabei sind die einzelnen Schritte wie folgt benannt:

Schritt 201 beschreibt die Erhebung und Definition der Anforderungen ("Requirements"). Anschließend erfolgt in Schritt 202 das Systemdesign ("System Design"), gefolgt von der Definition des Systemsamples in Schritt 203 ("System Sample Definition"). Im nächsten Schritt, 204, wird das Systemsample aufgebaut ("System Sample Setup"). Danach finden in Schritt 205 die Messungen am System statt ("System Measurements"). Auf Basis dieser Ergebnisse wird in Schritt 206 ein glaubwürdiges Systemmodell erstellt ("Credible System Model"), welches wiederum in Schritt 207 durch Simulationen verifiziert und validiert wird ("Verification & Validation by Simulation").

Die praktische Validierung erfolgt anschließend durch mehrere Stufen: Schritt 208 beinhaltet das eigentliche Systemsample ("System Sample"), gefolgt von Labortests in Schritt 209 ("Validation by Lab Tests") sowie Tests unter realen Bedingungen in Schritt 210 ("Validation by Real World Tests"). Abschließend werden in Schritt 211 die Tests des Originalherstellers (OEM) durchgeführt ("OEM Tests").

Häufig soll auf Basis der Systemmessungen 205 nicht nur ein nomineller Parametersatz bestimmt werden, sondern auch dessen Unsicherheit durch eine stochastische Verteilung charakterisiert werden. Diese Information kann im linken Pfad des V-Modell (System-Synthese, umfassend 201 und 202) genutzt werden, um eine Abwägung zwischen Performanz und Robustheit von Regelfunktionen zu erreichen. Dies kann zur Design- oder zur Laufzeit erfolgen. Im rechten Pfad des V-Modells (System-Analyse, umfassend 207 bis 211) kann die charakterisierte Unsicherheit zur Freigabeargumentation auf Basis verlässlicher Modelle verwendet werden.

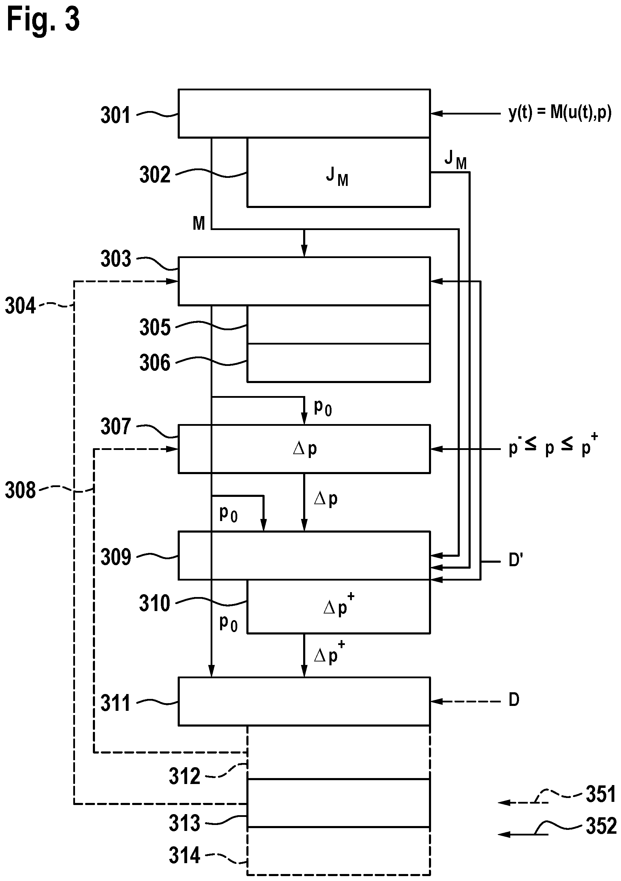

Ausführungsvarianten der Erfindung sind in fünf wichtige Schritte untergliedert, deren technischer Hintergrund im Folgenden genauer erläutert werden. Die Schritte sind mit weiteren Einzelheiten in Fig. 3 dargestellt. In Fig. 3 bezeichnet 301 die Verarbeitung des System-Modells, 302 einen Mechanismus zur Berechnung der Linearisierung $J_{\mathcal{M}}$, 303 die Nominelle Identifikation, 304 den Vorgang, dass ggf. ein Update der nominellen Identifikation erfolgt, 305 das Optimierungsproblem, 306 den numerischen Solver, 307 die Konstruktion einer a-priori Schätzung für $\Delta p$, 308 den Vorgang, dass ggf. ein Update der a-priori Schätzung vorgenommen wird, 309 die Linearisierte Bayes'sche Regression, 310 das Berechnungsverfahren für die a-posterior Verteilung $\Delta_p^+$ 311 das Ergebnis und die Applikation, 312 die Anwendung des Algorithmus auf das nächste oder ein neues Datenpaket, 313 die Überprüfung des Ergebnisses, 314 die Erstellung des Surrogat-Modells. Weiter bezeichnen 351 optionale und 352 extern benötigte Pfade.

Die grundlegende Idee zur Bestimmung einer verlässlichen Parameterschätzung (engl. credible parameter estimate) im Rahmen von Ausführungsbeispielen der Erfindung setzt bei der Zerlegung

$$p = p_0 + \Delta p \qquad\qquad (1)$$

an. Dabei ist $p_0$ das Ergebnis einer nominellen Identifikation 303 ohne Betrachtung von Unsicherheiten und steht im Zentrum von Schritt 2. Darauf aufbauend findet die Bestimmung des stochastischen Anteils $\Delta p$ statt, der es ermöglicht, Konfidenzintervalle für die Parameter und die Ausgangsgrößen zu bestimmen.

### 1. Systemmodell.

Ausgangspunkt ist gemäß Schritt 301 in Fig. 3 ein Systemmodell, d. h. ein Modell des technischen Systems 50, das den strukturellen Zusammenhang zwischen zu identifizierenden Parametern p, einer gegebenen Systemanregung u(t), und Ausgangsgrößen y(t), die den Messgrößen entsprechen, herstellt:

$$y(t) = \mathcal{M}(u(t), p). \qquad\qquad (2)$$

Das Modell hat typischerweise zusätzliche interne Zustandsgrößen x(t) und liegt in Form eines Differentialglei-

chungssystems vor:

$$\dot{x}(t) = f(x(t), u(t), p)$$
$$y(t) = g(x(t), u(t), p)$$

(3)

Im Folgenden werden als Messdaten die Zeitreihen der Ein- und Ausgangsgrößen

$$\mathcal{D} = \{\overline{u}_k, \overline{y}_k\}_{k_0 \leq k \leq k_\mathrm{f}}$$

vorausgesetzt. Dabei wird zur Vereinfachung der Notation eine konstante Abtastzeit

$$h > 0 \ \text{ mit } y_k = y(t_k)$$

und

$$t_k = kh$$

angesetzt. Zu Vektoren oder Matrizen aggregierte Messsignale sind durch Großbuchstaben $\overline{U}$ und $\overline{Y}$ gekennzeichnet.

Ausführungsvarianten der Erfindung benötigen die partielle Ableitung $\partial\mathcal{M}/\partial p$ des Modells bezüglich der Parameter in der Umgebung eines festen Werts $p_0$.

Diese kann beispielsweise numerisch über ein finite Differenzenverfahren erfolgen, sofern das Modell nicht in analytischer Form vorliegt. Um implizite Differenziationen zu umgehen, ist es zweckmäßig, das Modell $\mathcal{M}$ in eine Eingangs-Ausgangs-Darstellung der Form

$$\mathcal{M}: \ y_k = F\left(p; \underbrace{y_{k-1}, \dots y_{k-N}, u_k, \dots, u_{k-M}}_{\psi_k}\right) = F(p, \psi_k)$$

(4)

zu überführen. Der Übergang in eine zeitdiskrete Darstellung hat den Vorteil, dass die internen Zustandsgrößen durch vergangene Werte der Ein- und Ausgänge ersetzt werden können, welche unmittelbar in den Daten D vorhanden sind. Die benötigte partielle Ableitung des Modells an einer gegebenen Stelle $p_0$ ist somit wie folgt bestimmt:

$$\mathrm{J}_{\mathcal{M}}(u_k, p_0) = \left.\frac{\partial F(p, \psi_k)}{\partial p}\right|_{p = p_0}.$$

(5)

Aufgrund der in (1) nicht explizit ersichtlichen Gedächtniseigenschaft des Modells $\mathcal{M}$ hängt der Wert der Jacobimatrix auch von den vergangenen Eingangs- bzw. Ausgangswerten ab, wie in (4) zu erkennen ist.

Allgemeiner Fall (numerische Approximation):

Hier erfolgt eine Approximation der Jacobi-Matrix $\partial\mathcal{M}/\partial p$ durch ein numerisches Verfahren, z.B. finite Differenzen. Die Anzahl der benötigten Auswertungen des Modells (2) hängt von der Anzahl der Parameter und der Ausgangsgrößen ab.

Spezialfall 2 (Sensitivitäts-ODE):

Hier liegt das Modell in Form von analytischen Funktionen (3) vor, und es kann der aktuelle Wert der Jacobi-Matrix $\mathrm{J}_{\mathcal{M}}$ über Sensitivitätsdifferenzialgleichungen für mit $S = \partial_x/\partial_p$ bestimmt werden. Über Anwendung der Kettenregel ergibt sich der folgende Zusammenhang:

$$J_{\mathcal{M}}(u_k, p_0) = \frac{\partial g}{\partial p}\bigg|_{(x_k, u_k, p_0)} + \frac{\partial g}{\partial x}\bigg|_{(x_k, u_k, p_0)} S(t_k)$$

$$\dot{S}(t_k) = \frac{\partial f}{\partial x}\bigg|_{(x_k, u_k, p_0)} S(t_k) + \frac{\partial f}{\partial p}\bigg|_{(x_k, u_k, p_0)}, t_k > t_0, \quad S(t_0) = \frac{\partial x_0}{\partial p}\bigg|_{p_0}$$

Zur Berechnung des zeitlichen Verlaufs der Jacobi-Matrix $J_{\mathcal{M}}$ an den geforderten Zeitpunkten $t_k$ muss somit ein dynamisches System zusätzlich zu (3) kosimuliert werden. Weitere Auswertungen des Modells wie im allgemeinen Fall, sind nicht nötig.

Spezialfall 1 (LPV-System):

Im Fall einer linearen Dynamik mit nichtlinearen Parametereingriffen mit

$$f = A(p)x + B(p)u \text{ und } g = C(p)x + D(p)u$$

kann über den komplexen zeitdiskreten Bildbereich ein geschlossener Zusammenhang für das Eingangs-Ausgangs-Modell (4) hergeleitet werden. Unter der beispielhaften Verwendung der zero-order-hold-Methode folgt für die zeitdiskrete Übertragungsfunktion

$$G(z^{-1}) \quad = \frac{\text{adj}\left(C(p)[I - e^{A(p)h}z^{-1}]^{-1}\int_0^h e^{A(p)t}dtB(p)\,z^{-1} + D(p)\right)}{\det\left(C(p)[I - e^{A(p)h}z^{-1}]^{-1}\int_0^h e^{A(p)t}dtB(p)\,z^{-1} + D(p)\right)} = \frac{b_0(p) + b_1(p)z^{-1} + \cdots + b_N(p)z^{-M}}{1 + a_1(p)z^{-1} + .. + a_N(p)z^{-N}}, \quad (6)$$

die ein gebrochen-rationales Polynom in der Bildvariablen $z^{-1}$ ist. Somit entspricht (6) im Zeitbereich der Differenzengleichung

$$y_k = \sum_{n=1}^{N} a_n(p)y_{k-n} + \sum_{n=0}^{M} b_n(p)u_{k-n} = \underbrace{[a_1 \cdots a_N,\ b_0 \cdots b_N](p)}_{\theta^T(p)}\underbrace{\begin{bmatrix} y_{k-1} \\ \vdots \\ y_{k-N} \\ u_k \\ \vdots \\ u_{k-M} \end{bmatrix}}_{\psi_k} = \theta^T(p)\psi_k. \quad (7)$$

Dies ermöglicht eine effiziente und analytische Berechnung der benötigen Jacobi-Matrix aus (5) über die Vorschrift

$$J_{\mathcal{M}}(u_k, p_0) = J_\theta^T(p_0)\psi_k \text{ mit } J_\theta(p_0) = \mathrm{d}\theta(p)/\mathrm{d}p|_{p_0}.$$

.

## 2. Nominelle Identifikation.

Die Identifikation eines nominellen Parametersatzes für ein gegebenes Modell (1) und Daten $\mathcal{D}$ ist durch bekannte Methoden des Stands der Technik möglich, s. unter anderem Ljung, Lennart. "System identification." Signal analysis and prediction. Boston, MA: Birkhäuser Boston, 1998 und Bishop, Christopher, and Nasser Nasrabadi. Pattern recognition and machine learning. NY: Springer, 2006.

Ziel ist die Minimierung eines Fehlermaßes $Q(e) \in \mathbb{R}$ zwischen Messdaten und Daten, die durch das Residuum $e_k(p) = \overline{y}_k - \mathcal{M}(\overline{u}_k, p)$ vorgesehen sind. Für den kompletten berücksichtigen Datensatzes ergibt sich der Fehlervektor e und der optimale nominelle Parametersatz zu

$$p_0 = \arg\min_p Q(e). \quad (8)$$

Spezialfall:

Die Methode ist nicht auf einen speziellen Algorithmus zur Bestimmung von $p_0$ limitiert. Die Wahl eines Maximum Likelihood oder Maximum Posterior Schätzers (engl. Ridge Regression) bietet aber Vorteile in Kombination mit der linearisierten Bayes'schen Regression aus Schritt 4. In Abhängigkeit des Regularisierungsparameters $\lambda \geq 0$ ergibt sich das nichtlineare Optimierungsproblem

$$p_0 = \arg\min_p Q = [\bar{Y} - F(p, \bar{\Psi})]^{\mathrm{T}}[\bar{Y} - F(p, \bar{\Psi})] + \lambda\, p^{\mathrm{T}}p. \qquad (9)$$

### 3. Konstruktion einer a-priori-Schätzung (engl. prior).

Für die Anwendung der Bayes'schen Regression ist die Konstruktion einer a-priori Verteilung für den stochastischen Anteil $\Delta p$ notwendig. Hier ist zu unterscheiden, ob der Algorithmus initial oder iterativ verwendet wird. Für die Initialisierung der Verteilung wird die beispielhafte Wahl

$$\Delta p \sim \mathcal{N}(\mu_p, \Sigma_p) \quad \text{mit } \mu_p = 0, \qquad (10)$$

angesetzt. Das Verfahren ist nicht auf eine bestimmte Verteilungsannahme für die a-priori Verteilung limitiert. Der Ansatz (10) ermöglicht allerdings im weiteren Verlauf eine geschlossene Lösung des Bayes'schen Regressionsproblems und ermöglicht somit auf die Anwendbarkeit zur Laufzeit. Die Kovarianz $\Sigma_p$ in (10) kann entweder direkt aus bekannten Standardstreuungen

$$\Sigma_p = \mathrm{diag}(\sigma_{\mathrm{p,i}}^2)$$

oder aus bekannten (physikalischen) Grenzen

$$p^- \leq p \leq p^+ \text{ mit } \Sigma_p = \tfrac{1}{12}\mathrm{diag}(p^+ - p^-)^2$$

konstruiert werden.

Wurde der Algorithmus bereits für ein Teil der verfügbaren Daten durchlaufen oder sind in der Zwischenzeit neue Daten vorhanden, können die a-posteriori Schätzungen aus Schritt 4 als neue a-priori- Schätzungen verwendet werden, d.h.

$$\Sigma_p \leftarrow \Sigma_p^+.$$

Der Mittelwert kann entweder zu

$$\mu_p \leftarrow \mu_p^+$$

gesetzt werden, oder der Mittelwert wird im deterministischen Anteil berücksichtigt

$$(p_0 \leftarrow p_0 + \mu_p \text{ und } \mu_p = 0).$$

Letzteres entspricht einem Update des Linearisierungspunkts und ist ggf. mit der erneuten Auswertung der Jacobi-Matrix (5) verbunden.

### 4. Linearisierte Bayes'sche Regression.

Die Grundlage der Bayes'schen Regression der verbleibenden Komponente $\Delta p$ der zu identifizierenden Parameter ist der residuale Fehler e, welcher trotz der nominellen Parameterschätzung p0 verbleibt. Um ein lineares Regressionsproblem zu erhalten, wird das um die Stelle p0 linearisierte Modell

$$y_k = \mathcal{M}(u_k, p_0) + J_{\mathcal{M}}(u_k, p_0)\Delta p + \varepsilon_k \qquad (11)$$

angesetzt. Dabei ist

$$\varepsilon_k \sim \mathcal{N}(0, \beta^{-1})$$

ein Fehlerterm, welcher das Messrauschen mit Varianz $\sigma_y^2$ und das Vertrauen ins Modell über den Präzisionsparameter

$$\cdot \beta^{-1} = \sigma_y^2 + \sigma_{\text{model}}^2$$

repräsentiert. Letzterer kann über den Standardfehler $\sigma_{\text{model}}$ auch den Linearisierungsfehler berücksichtigen. Das resultierende Regressionsproblem ist durch

$$\bar{y}_k - \mathcal{M}(\bar{u}_k, p) = J_{\mathcal{M}}(p_0)\Delta p \quad \Leftrightarrow \quad e_k = J_{\mathcal{M}}(p_0)\Delta p \qquad (12)$$

gegeben. Anwendung des Satz von Bayes liefert den folgenden Zusammenhang zwischen der a-priori Verteilung $p(\Delta p | \mathcal{D}', \beta)$ gegeben einem (Unter-)Datensatz $\mathcal{D}' = \{\overline{U}', \overline{Y}\}$ und der a-posteriori Verteilung

$$\Delta p^+ \sim \Pr(y_k | \Delta p, \mathcal{D}', \beta) = \int \Pr(y_k | \Delta p) \Pr(\Delta p | \mathcal{D}', \beta) d(\Delta p). \qquad (13)$$

Für allgemeine Verteilungsformen ist eine numerische Approximation möglich. Da der Algorithmus auch rekursiv verwendet werden kann, wird an dieser Stelle explizit zwischen dem gesamten Datensatz $\mathcal{D}$ und dem Datensatz $\mathcal{D}'$ unterschieden. Dies bedeutet, dass nicht alle verfügbaren Daten verwendet werden müssen oder die bestehende Schätzung um neue Daten erweitert werden kann.

Für die Wahl (7) hingeben ergibt sich aus (13) eine Normalverteilung

$$\Delta p^+ \sim \mathcal{N}(\mu_p^+, \Sigma_p^+)$$

mit geschlossener Lösung

$$\mu_p^+ = \Sigma_p^+ \left( \Sigma_p^{-1} \mu_p + \beta \, J^{\text{T}}_{\mathcal{M}}(\overline{U}', p_0)[\overline{Y}' - \mathcal{M}(\overline{U}', p_0)] \right)$$
$$\left( \Sigma_p^+ \right)^{-1} = \Sigma_p^{-1} + \beta \, J_{\mathcal{M}}^{\text{T}}(\overline{U}', p_0) \, J_{\mathcal{M}}(\overline{U}', p_0). \qquad (14)$$

Für den in (6)-(7) dargestellten Spezialfall 2 der Systemrepräsentation vereinfachen

$$\mu_p^+ = \Sigma_p^+ \left( \Sigma_p^{-1} \mu_p + \beta \, \overline{\Psi}'^{,\text{T}} J_\theta(p_0) \, [\overline{Y}' - \theta^{\text{T}}(p_0)\overline{\Psi}'] \right)$$
$$\left( \Sigma_p^+ \right)^{-1} = \Sigma_p^{-1} + \beta \, J_\theta^{\text{T}}(p_0)[\overline{\Psi}'\overline{\Psi}'^{,\text{T}}] J_\theta(p_0), \qquad (15)$$

was eine direkte Auswertung, d.h. ohne numerisches Sampling, der a-posteriori ermöglicht. Die Berechnung der a-posteriori Verteilung (13) reduziert sich zu Matrix-Vektor-Multiplikationen, da die Jacobi- Matrizen $J_\theta(p_0)$ vorberechnet werden können.

## 5. Ergebnis & Applikation.

Der letzte Schritt von Ausführungsvarianten der Erfindung bringt beide Teile der Gesamtschätzung wieder zusammen und konsolidiert $p_0$ aus Schritt 2 und $\Delta p$ aus Schritt 4 zur Gesamtschätzung.

Dies kann je nach Situation folgende Teilaspekte umfassen:

Die Linearisierungsannahme impliziert, dass der Mittelwert der Bayes'schen a-posteriori Verteilung klein im Vergleich zu $p_0$ sein sollte, d.h. $\mu_p^+ \ll p_0$. Ist dies nicht der Fall, ist dies ein Indiz für eine verbesserungsbedürftige Schätzung in Schritt 2ff, d.h. das Optimierungsproblem sollte adaptiert werden, beispielsweise durch eine Anpassung des Regularisierungsparameters $\lambda$ in (9) oder des Präzisionsparameters $\beta$ im Regressionsproblem (11).

Ein weiteres Indiz stellt die signifikante Abweichung der Messdaten aus einem geeigneten Konfidenz-Intervall dar. Die Wahl $\lambda = t(\Sigma p)/\beta$ stellt zudem eine konsistente Parametrierung beider Schritte dar. Wobei t als Trace-Operator gewählt werden kann und sich auf die a-priori $\Sigma_p$ oder die a-posteriori Varianz $\Sigma_p^+$ beziehen kann.

Wie in Schritt 3 beschrieben, können Ausführungsvarianten der Erfindung in rekursiver Art auf Unterdatensätze $\mathcal{D}'$ angewendet werden. Sollte dies der Fall sein, kann hier der nächste Datenabschnitt ausgewählt werden und die vorigen Schritte werden wiederholt. Dies umfasst auch die Ausführung der Laufzeit, d.h. wenn seit dem nächsten Aufruf neue Daten gesammelt wurden, kann der Algorithmus ggf. erneut durchlaufen werden.

Für bestimmte Modellstrukturen ist es möglich, ein deterministische Surrogat-Modell aus den identifizierten Parameterverteilungen zu generieren. Hierfür können bekannte Methoden verwendet werden. Das resultiere Modell mit identifizierten Parameterverteilungen kann anschließend in folgenden Anwendungen appliziert werden: Synthese oder Update eines Regelalgorithmus' zur Design- oder Laufzeit, Analyse von Sensitivitäten oder Zuverlässigkeitsanalyse in der Verifikation & Validierung.

Die Bestimmung optimaler Eingangssignale erfolgt durch die obigen Schritte.

Ist eine nominelle Schätzung bereits bekannt, kann Schritt 2 "Nichtlineare Identifikation" ggf. entfallen. In diesem Fall muss p0 extern bzw. vom Nutzer vorgegeben werden.

Ausführungsvarianten der Erfindung können in jedem technischen Kontext verwendet werden, dem eine modellbasierte Regelfunktion und/oder Verifikation auf Basis verlässlicher Modelle zu Grunde liegt. Der initiale Anwendungsfall ist die Identifikation der Modellparameter für ein Fahrzeugmodell der Querdynamik.

Ein weiterer Anwendungsfall ist die Identifikation des Längsführungsverhalten von Fahrzeugen, die Lenkungsregelung (z.B. Zahnstangenpositionsregelung) oder der Bremsenregelkreis von Fahrzeugen dar (z.B. ESP, decoupled/integrated power brake, by-wire actuator,...). Weitere naheliegende Anwendungsfälle sind die Fahrdynamikregelung, die (Großraum-)Robotik oder die Regelung von elektrischen Maschinen.

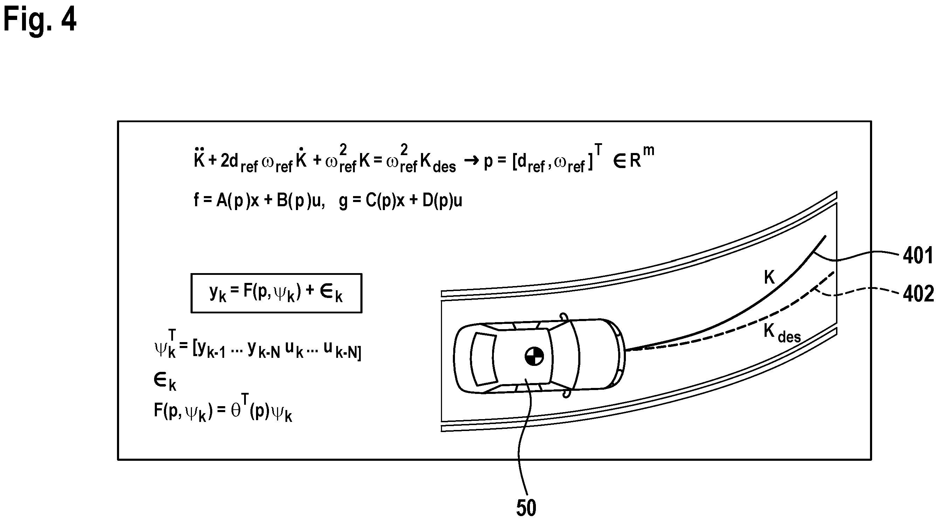

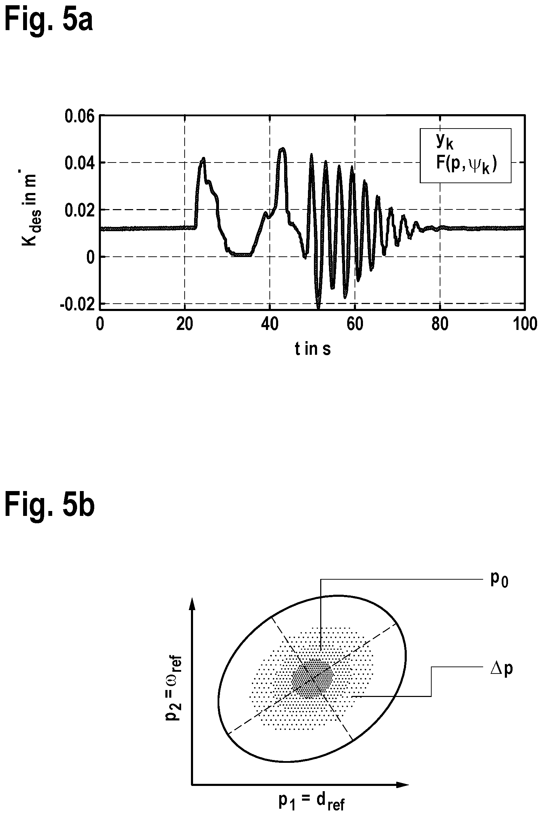

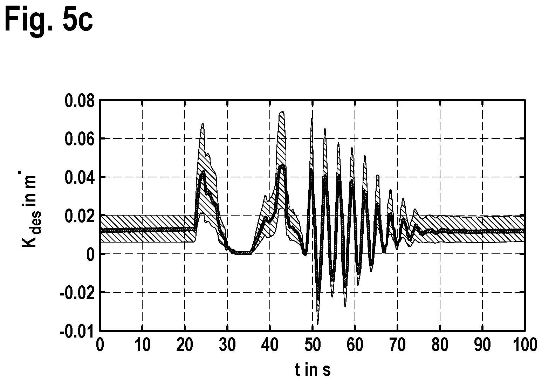

Eine wichtige Ausführungsvariante ist die Identifikation eines geschlossenen Regelkreises zur Fahrzeug-Querführung. Hierzu sind weitere Einzelheiten in Fig. 4 dargestellt. Dabei wird ein Streckenmodell angesetzt, welches dem Spezialfall 1 aus Schritt 1 genügt. Ziel der Untersuchung ist es das Übertragungsverhalten von der gewünschten Krümmung 402 der Fahrzeugtrajektorie auf die tatsächliche Krümmung 401 zu untersuchen. Auf Basis der vorhandenen Messdaten (siehe Fig. 5a) kann im Rahmen von Schritt 2 der Erfindung eine nominelle Parameterschätzung p0 bestimmt werden, die das wesentliche Verhalten beschreibt. Die verbleibende Unsicherheit wird durch die Verteilung von $\Delta$ p aus Schritt 4 quantifiziert. Die resultierende Verteilung kann im Parameterraum (siehe Fig. 5b) oder als Konfidenzintervalls des Systemausgangs (siehe Fig. 5c) dargestellt werden.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

**Patentansprüche**

1.  Verfahren (100) für eine Identifikation von Parameterverteilungen zur Modellierung eines technischen Systems (50), umfassend die nachfolgenden Schritte:

    - Bestimmen (101) einer nominalen Parameterschätzung basierend auf bereitgestellten Messdaten und wenigstens einem vorgegebenen Modell einer Systemdynamik des technischen Systems (50),
    - Bestimmen (102) einer Verteilung von Parameterveränderungen auf Basis einer Quantifizierung einer parameterbedingten Unsicherheit der nominalen Parameterschätzung,
    - Bereitstellen (103) der nominellen Parameterschätzung und der Verteilung der Parameterveränderungen als Basis für die Modellierung des technischen Systems (50) unter Berücksichtigung der parameterbedingten Unsicherheit.

2.  Verfahren (100) nach Anspruch 1,
    **dadurch gekennzeichnet,**
    **dass** das Verfahren (100) zur Identifikation der Parameter in der Form von Modellparametern eines geschlossenen Regelkreises zur Fahrzeug-Kontrolle und vorzugsweise Fahrzeug-Querführung eingesetzt wird.

3.  Verfahren (100) nach einem der vorhergehenden Ansprüche,
    **dadurch gekennzeichnet,**

**dass** das Verfahren (100) für eine Identifikation der Parameter für Fahrzeugmodelle vorgesehen ist, die vorzugsweise für die Fahrzeugquerführung und/oder Fahrzeuglängsführung und/oder Fahrdynamikregelung und/oder Komponentenentwicklung und/oder Lenkungsregelung und/oder Bremsregelung eingesetzt werden.

4. Verfahren (100) nach einem der vorhergehenden Ansprüche,
   **dadurch gekennzeichnet,**
   **dass** das Verfahren (100) zur Untersuchung eines Übertragungsverhaltens von einer gewünschten Krümmung (402) einer Fahrzeugtrajektorie auf eine tatsächliche Krümmung (401) der Fahrzeugtrajektorie eingesetzt wird, wobei die nachfolgenden Schritte vorgesehen sind:

   - Bereitstellen des vorgegebenen Modells in der Form eines Modells eines geschlossenen Regelkreises zur Fahrzeug-Querführung,
   - Durchführen der nominalen Parameterschätzung, um eine erste Schätzung wenigstens eines Parameters des Modells auf Basis der bereitgestellten Messdaten vorzunehmen,
   - Durchführen der Quantifizierung der parameterbedingten Unsicherheit, welche eine verbleibende Unsicherheit in den geschätzten Parametern bereitstellt,
   - Durchführen der Bestimmung der Verteilung der Parameterveränderungen auf Basis der durchgeführten Quantifizierung,
   - Durchführung der Modellierung des technischen Systems (50) auf Basis der nominellen Parameterschätzung und der Verteilung der Parameterveränderungen,
   - Anpassen einer Regelungsvorgabe für die Fahrzeug-Querführung auf Basis der Modellierung.

5. Verfahren (100) nach einem der vorhergehenden Ansprüche,
   **dadurch gekennzeichnet,**
   **dass** die Bestimmung der nominalen Parameterschätzung umfasst:

   - Minimieren eines nominellen Fehlers zwischen den bereitgestellten Messdaten und dem vorgegebenen Modell, insbesondere ohne Berücksichtigung von Unsicherheiten.

6. Verfahren (100) nach einem der vorhergehenden Ansprüche,
   **dadurch gekennzeichnet,**
   **dass** die Bestimmung der Verteilung der Parameterveränderungen umfasst:

   - Charakterisieren der parameterbedingten Unsicherheit in der Form einer aus der nominalen Parameterschätzung verbleibenden Modell-Unsicherheit.

7. Verfahren (100) nach einem der vorhergehenden Ansprüche,
   **dadurch gekennzeichnet,**
   **dass** die Bestimmung der Verteilung und insbesondere die Charakterisierung der parameterbedingten Unsicherheit mittels eines linearisierten Bayes'schen Ansatzes durchgeführt wird.

8. Verfahren (100) nach einem der vorhergehenden Ansprüche,
   **dadurch gekennzeichnet,**
   **dass** die Modellierung des technischen Systems (50) unter Berücksichtigung der parameterbedingten Unsicherheit dadurch vorgesehen ist, dass die nominale Parameterschätzung und die Verteilung der Parameterveränderungen zu einer Gesamtschätzung konsolidiert werden.

9. Computerprogramm (20), umfassend Befehle, die bei der Ausführung des Computerprogramms (20) durch wenigstens einen Computer (10) diesen veranlassen, das Verfahren (100) nach einem der vorhergehenden Ansprüche auszuführen.

10. Vorrichtung (10) zur Datenverarbeitung, die eingerichtet ist, das Verfahren (100) nach einem der Ansprüche 1 bis 8 auszuführen.

11. Computerlesbares Speichermedium (15), umfassend Befehle, die bei der Ausführung durch wenigstens einen Computer (10) diesen veranlassen, die Schritte des Verfahrens (100) nach einem der Ansprüche 1 bis 8 auszuführen.

# Fig. 1

**Fig. 2**

# Fig. 3

# Fig. 4

$$\ddot{K} + 2d_{ref}\,\omega_{ref}\dot{K} + \omega_{ref}^2 K = \omega_{ref}^2 K_{des} \rightarrow p = [d_{ref},\omega_{ref}]^T \in R^m$$

$$f = A(p)x + B(p)u, \quad g = C(p)x + D(p)u$$

$$\boxed{y_k = F(p,\psi_k) + \in_k}$$

$$\psi_k^T = [y_{k-1} \dots y_{k-N}\, u_k \dots u_{k-N}]$$

$$\in_k$$

$$F(p,\psi_k) = \theta^T(p)\psi_k$$

EP 4 783 058 A1

# Fig. 5a

# Fig. 5b

Fig. 5c

Europäisches Patentamt
European Patent Office
Office européen des brevets

# EUROPÄISCHER RECHERCHENBERICHT

**Nummer der Anmeldung**

EP 25 15 3223

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | LIONTI FABIEN ET AL: "Bayesian Approach for Parameter Estimation in Vehicle Lateral Dynamics", 17. Juni 2024 (2024-06-17), FOUNDATIONS OF INTELLIGENT SYSTEMS; [LECTURE NOTES IN COMPUTER SCIENCE; LECT.NOTES COMPUTER], SPRINGER NATURE SWITZERLAND, CHAM, PAGE(S) 249 - 259, XP047702348, ISSN: 0302-9743 ISBN: 978-3-031-62699-9 [gefunden am 2024-06-17] | 1-5,7-11 | INV. G06F30/15 B60W50/00 G06F30/20 |
| Y | * Zusammenfassung * * Teil 3 * * Abbildung 6(b) * * Seite 9, Absatz 2 * * Teil 4.2 * * das ganze Dokument * ----- | 6 | |
| X | Wischnewski Alexander: "Robust and data-driven control for autonomous racing", , 2. Mai 2023 (2023-05-02), XP093286174, Gefunden im Internet: URL:https://mediatum.ub.tum.de/doc/1693646 /zgtie2ycz2g2af9xfi7q0zsfq.DissertationWis chnewskiRobustAndDataDrivenControl.pdf * Zusammenfassung * * Teil 4.2 * * Teil 5.2 * * Teil 7.5 * * das ganze Dokument * ----- -/-- | 1,9-11 | **RECHERCHIERTE SACHGEBIETE (IPC)** G06F B60W B60L |

Der vorliegende Recherchenbericht wurde für alle Patentansprüche erstellt

| Recherchenort | Abschlußdatum der Recherche | Prüfer |
|---|---|---|
| München | 23. Juni 2025 | Dapp, Wolfgang |

EPO FORM 1503 03.82 (P04C03)

Seite 1 von 2

Europäisches
Patentamt

European
Patent Office

Office européen
des brevets

# EUROPÄISCHER RECHERCHENBERICHT

**Nummer der Anmeldung**

EP 25 15 3223

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | Shen Dan: "Path Following Control of Automated Vehicle Considering Uncertainties and Disturbances with Parametric Varying", , 28. April 2022 (2022-04-28), XP093286180, Gefunden im Internet: URL:https://hammer.purdue.edu/articles/thesis/Path_Following_Control_of_Automated_Vehicle_Considering_Model_Uncertainties_External_Disturbances_and_Parametric_Varying/19666500 * Zusammenfassung * * section 1.2 * * section 4 * * section 4.4 and 4.4.3 * ----- | 6 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| München | 23. Juni 2025 | Dapp, Wolfgang |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

 ...........................................................................
& : Mitglied der gleichen Patentfamilie, übereinstimmendes
Dokument

EPO FORM 1503 03.82 (P04C03)

Seite 2 von 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- System identification.. **LJUNG, LENNART**. Signal analysis and prediction. Birkhäuser Boston, 1998

- **BISHOP** ; **CHRISTOPHER** ; **NASSER NASRABADI**. Pattern recognition and machine learning. Springer, 2006